# EUROPEAN PATENT APPLICATION

(11) **EP 4 783 783 A2**
(43) Date of publication of application: **29.07.2026**
(21) Application number: 25226741.4
(22) Date of filing: 23.12.2025
(51) Int. Cl.: H10F 71/00, H10F 77/20

(54) **SOLAR CELL, SCREEN PRINTING PLATE STRUCTURE AND PHOTOVOLTAIC MODULE**

(30) Priority: 24.01.2025 CN 202510121041
(71) Applicant: Tongwei Solar (Meishan) Co., Ltd., Meishan, Sichuan 620041 (CN)
(72) Inventor: HUANG, Zhi, Meishan, 620041 (CN); YANG, Yongle, Meishan, 620041 (CN); CHEN, Shuai, Meishan, 620041 (CN); CHEN, Zhiwei, Meishan, 620041 (CN); QIAN, Jinliang, Meishan, 620041 (CN); LIAO, Jing, Meishan, 620041 (CN); QIN, Ling, Meishan, 620041 (CN); ZHAO, Shiqin, Meishan, 620041 (CN); DING, Xiaochun, Meishan, 620041 (CN); YAO, Qian, Meishan, 620041 (CN)
(74) Representative: Murgitroyd & Company

(57) **Abstract**

The present application discloses a solar cell, a screen plate structure, and a photovoltaic module. The solar cell includes a half-finished solar cell and a first electrode. The first electrode includes a plurality of first fingers and a plurality of first connecting portions. The plurality of first fingers are arranged at intervals along a first direction. Each of the first fingers extends along a second direction. The plurality of first connecting portions are arranged at intervals along the first direction. The first connecting portion is connected to the first finger. A portion of the first connecting portions are configured to be soldered with solder ribbons. A maximum height H1 of the first connecting portion satisfies: 4 µm ≤ H1 ≤ 10 µm.

## Description

### TECHNICAL FIELD

The present application relates to the field of solar cell technologies, and in particular, to a solar cell, a screen printing plate structure, and a photovoltaic module.

### BACKGROUND

With the advancement of photovoltaic technologies, the development of high-efficiency and low-cost solar cells and photovoltaic modules has consistently been a constant research focus in the photovoltaic industry. Reducing the paste consumption to achieve cost reduction is the development trend of the photovoltaic industry.

In related technologies, a width and height of fingers are generally reduced to decrease the paste consumption. However, limited by a screen printing process, it is impossible to effectively achieve finer fingers while maintaining good performance of an electrode. Moreover, reducing the height of the fingers will increase the contact resistivity at the contact region for fingers of the solar cell, which is not conducive to improving conversion efficiency of the solar cell. Additionally, it is also prone to lead to finger breakage during the soldering process.

### SUMMARY

Embodiments of the present application disclose a solar cell, a screen printing plate structure, and a photovoltaic module, which are capable of reducing a production defect rate of the solar cell and improving the performance of the solar cell, and also reducing production costs.

To achieve the above purpose, in a first aspect, the embodiments of the present application disclose a solar cell, including:
a half-finished solar cell;
a first electrode, the first electrode being disposed on the half-finished solar cell, the first electrode including a plurality of first fingers and a plurality of first connecting portions, where the plurality of first fingers are arranged at intervals along a first direction, each of the first fingers extends along a second direction, the plurality of first connecting portions are arranged at intervals along the first direction, the first connecting portion is connected to the first finger, and a portion of the first connecting portions are configured to be soldered to solder ribbons; and
a maximum height H1 of the first connecting portion satisfies: 4 µm ≤ H1 ≤ 10 µm, and the first direction intersects with the second direction.

As an optional implementation, in an embodiment of the first aspect of the present application, a smoothness factor of the first finger is less than a smoothness factor of the first connecting portion.

As an optional implementation, in an embodiment of the first aspect of the present application, the first electrode also includes a plurality of first busbars, the plurality of first busbars are arranged at intervals along the second direction, each of the first busbars extends along the first direction, and the first busbar intersects with the first connecting portion; and
the maximum height H1 of the first connecting portion is greater than a maximum height of the first busbar located at the first connecting portion.

As an optional implementation, in an embodiment of the first aspect of the present application, a maximum height of the first finger connected to the first connecting portion is H2, and H1 ranges from 1.2H2 to 3H2.

As an optional implementation, in an embodiment of the first aspect of the present application, a maximum height of the first finger connected to the first connecting portion is H2, and a difference between H1 and H2 ranges from 1 µm to 4 µm.

As an optional implementation, in an embodiment of the first aspect of the present application, a maximum height H2 of the first finger connected to the first connecting portion satisfies: 4 µm ≤ H2 ≤ 6 µm.

As an optional implementation, in an embodiment of the first aspect of the present application, the solar cell also including a second electrode. The second electrode is disposed on the half-finished solar cell, and the second electrode includes a plurality of second fingers and a plurality of second connecting portions. The plurality of second fingers are arranged at intervals along the first direction, each of the second fingers extends along the second direction, the plurality of second connecting portions are arranged at intervals along the first direction, the second connecting portion is connected to the second finger, and a portion of the second connecting portions are configured to be soldered to the solder ribbons.

A maximum height of the second connecting portion is H3, and H1 > H3; preferably
the maximum height H3 of the second connecting portion satisfies: 4 µm ≤ H3 ≤ 8 µm.

As an optional implementation, in an embodiment of the first aspect of the present application, a polarity of the first electrode and a polarity of the second electrode are opposite;
the first electrode is disposed on a front surface of the half-finished solar cell, and the second electrode is disposed on a rear surface of the half-finished solar cell; or;
both the first electrode and the second electrode are disposed on a rear surface of the half-finished solar cell.

As an optional implementation, in an embodiment of the first aspect of the present application, the first connecting portion includes a finger connection line and a busbar connection line, and at least a portion of the finger connection line overlaps with the busbar connection line; preferably, the busbar connection line is covered on the finger connection line.

As an optional implementation, in an embodiment of the first aspect of the present application, a corresponding region between the busbar connection line and the half-finished solar cell has a silicon-containing dielectric layer.

As an optional implementation, in an embodiment of the first aspect of the present application, a total length L1 of the busbar connection line and/or the finger connection line in the second direction ranges from 1 mm to 1.5 mm; and/or,
a minimum width W1 of the busbar connection line and/or the finger connection line in the first direction ranges from 10 µm to 20 µm; and/or,
a maximum width W2 of the busbar connection line in the first direction ranges from 50 µm to 80 µm; and/or,
a maximum width W3 of the finger connection line in the first direction ranges from 25µm to 40µm.

In a second aspect, the present application discloses a screen plate structure applied to a solar cell. The solar cell includes a half-finished solar cell, the screen printing plate structure includes a substrate, and the substrate includes a main body portion and a thickened portion. The thickened portion is disposed on the main body portion along a thickness direction of the main body portion. The main body portion is provided with a plurality of first openings, the plurality of first openings penetrate through the main body portion along the thickness direction of the main body portion, the plurality of first openings are arranged at intervals along a first direction, and each of the first openings extends along a second direction, the first opening is configured to form a first finger on the half-finished solar cell.

The thickened portion is provided with a second opening extending along the second direction, and the second opening corresponds to at least one of the first openings and penetrates through the main body portion along the thickness direction of the main body portion to communicate with the first opening. The second opening is configured to form a first connecting portion on the half-finished solar cell, enabling the first connecting portion to be connected to the first finger, and the first connecting portion is configured to be connected to solder ribbons.

The first direction intersects with the second direction.

As an optional implementation, in an embodiment of the second aspect of the present application, each of the first opening includes a plurality of sub-openings, the plurality of sub-openings are arranged at intervals along the second direction, the thickened portion is located between at least two adjacent sub-openings where the second opening connects the two adjacent sub-openings.

As an optional implementation, in an embodiment of the second aspect of the present application, a thickness H4 of the thickened portion ranges from 1µm to 3µm; and/or
an opening depth H5 of the first opening ranges from 4µm to 10µm.

In a third aspect, the present application also discloses a photovoltaic module. The photovoltaic module includes the solar cell as described in the first aspect above, or the photovoltaic module includes the solar cell manufactured by the screen printing plate structure as described in the second aspect above.

The present application discloses a solar cell, a screen printing plate structure, and a photovoltaic module. A first electrode includes a plurality of first fingers and a plurality of first connecting portions, a portion of the first connecting portions are configured to be soldered with solder ribbons, and a maximum height H1 of the first connecting portion satisfies: 4 µm ≤ H1 ≤ 10 µm. Since a tin-based alloy on a surface of the solder ribbon will react with the first connecting portion during welding, the tin-based alloy will etch away a certain amount of a conductive metal material in the first connecting portion, forming a conductive metal-tin-lead alloy system. When a height of the conductive metal material in the first connecting portion is too low, it may not provide a sufficient amount of conductive metal material for the conductive metal-tin-lead alloy system formed during soldering. Consequently, the current collected by the solar cell through the first finger may not be transported out through the solder ribbon, that is, unexpected finger breakage occurs between the first finger and the solder ribbon. Therefore, by setting the maximum height H1 of the first connecting portion within the above range, it is beneficial for reducing a likelihood of the unexpected issues such as the finger breakage. Moreover, by setting the height in a reasonable range, an unexpected excessively-high contact resistivity between a location of the first finger and the first connecting portion is avoided, thereby being more conducive to improving the conversion efficiency of the solar cell.

At the same time, by controlling the maximum height of the first connecting portion within an optimal height range, the paste consumption for printing the first connecting portion is reduced, thereby facilitating better control of a production cost of the solar cell.

### BRIEF DESCRIPTION OF THE DRAWINGS

To more clearly illustrate technical solutions of the embodiments of the present application, the drawings required for d the embodiments will be briefly introduced in the following. Obviously, the drawings in the following description are only some embodiments of the present application. For a person with ordinary skill in the art, other drawings may be obtained from these drawings without creative effort.
FIG. 1 is a schematic structural diagram of a first electrode of a solar cell provided by embodiments of the present application.
FIG. 2 is an enlarged schematic view of an area A in FIG. 1.
FIG. 3 is a schematic cross-sectional structural diagram of a first connecting portion and a first finger provided by embodiments of the present application.
FIG. 4 is a schematic structural diagram of a second electrode of a solar cell provided by embodiments of the present application.
FIG. 5 is an enlarged schematic view of an area B in FIG. 4.
FIG. 6 is a schematic cross-sectional structural diagram of a first connecting portion and a second connecting portion provided by embodiments of the present application.
FIG. 7 is a cross-sectional profile diagram of a first connecting portion provided by embodiments of the present application.
FIG. 8 is a cross-sectional profile diagram of a second connecting portion provided by embodiments of the present application.
FIG. 9 is an enlarged schematic view of an area C in FIG. 2.
FIG. 10 is an enlarged schematic view of an area D in FIG. 5.
FIG. 11 is a diagram illustrating calculation of a smoothness factor in the present application based on a finger morphology captured by a 3D microscope.
FIG. 12 is a schematic structural diagram of a screen plate structure provided by an embodiment of the present application.
FIG. 13 is a schematic structural diagram of a screen plate structure with a reinforcement structure provided by embodiments of the present application.
FIG. 14 is an enlarged schematic view of an area E in FIG. 13.
FIG. 15 is a schematic structural diagram of a screen plate structure without a thickened portion but with a reinforcement structure provided by embodiments of the present application.
FIG. 16 is a cross-sectional view of a screen plate structure provided by embodiments of the present application.

### Reference numerals:

100. solar cell; 10. half-finished solar cell; 10a. front surface; 10b. rear surface; 20. first electrode; 21. first finger; 22. first connecting portion; 221. busbar connection line; 222. finger connection line; 23. first busbar; 30. second electrode; 31. second finger; 32. second connecting portion; 33. second busbar;
X. first direction; Y. second direction;
H1. maximum height of first connecting portion; H2. maximum height of first finger connected to first connecting portion; H3. maximum height of second connecting portion; H4. height of thickened portion; H5. opening depth of first opening;
L1. total length of busbar connection line and/or finger connection line on second direction; W1. minimum width of busbar connection line and/or finger connection line on first direction; W2. maximum width of busbar connection line on first direction; W3. maximum width of finger connection line on first direction;
200. screen printing plate structure; 210. substrate; 201. main body portion; 2011. first opening; 2011a. sub-opening; 202. thickened portion; 202a. second opening; 203. reinforcement structure;
H4. thickness of thickened portion; H5. opening depth of first opening; L1. length of second opening on second direction; W4. minimum width of second opening on first direction; W5. maximum width of second opening on first direction.

### DETAILED DESCRIPTION OF THE EMBODIMENTS

The technical solutions in embodiments of the present application will be clearly and completely described below with reference to the accompanying drawings in the embodiments of the present application. Apparently, the described embodiments are only some embodiments of the present application, rather than all the embodiments of the present application. Based on the embodiments of the present application, all other embodiments obtained by a person with ordinary skill in the art without creative efforts shall fall within the scope of protection of the present application.

In the present application, the orientation or positional relationship indicated by terms such as "upper", "lower", "left", "right", "front", "rear", "top", "bottom", "inner", "outer", "vertical", "horizontal", "transverse", and "longitudinal" are based on the orientations or positional relationships shown in the drawings. These terms are mainly used for better describing the present application and embodiments of the present application, and are not intended to limit the indicated devices, elements, or components to have a specific orientation or to be constructed and operated in a specific orientation.

Furthermore, some of the above terms may be used for representing other meanings in addition to orientation or positional relationships. For example, the term "upper" may also be used for indicating a certain dependency or connection relationship in some cases. A person with ordinary skill in the art may understand the specific meanings of these terms in the present application according to specific situations.

Moreover, the terms "mounted", "disposed", "provided", "connected", and "coupled" should be understood broadly. For example, a connection may be a fixed connection, a detachable connection, or an integral connection; it may be a mechanical connection, an electrical connection, or a direct connection, an indirect connection via an intermediary, or internal communication between two devices, elements, or components. A person with ordinary skill in the art may understand the specific meanings of these terms in the present application according to specific situations.

In addition, the terms such as "first", "second", and the like are mainly used for distinguishing different devices, elements, or components (which may be of a same or different type or construction), rather than for indicating or implying the relative importance or quantity of the indicated devices, elements, or components. Unless otherwise specified, "a plurality of" means two or more.

With the advancement of photovoltaic technologies, the development of high-efficiency and low-cost solar cells and modules has consistently been a constant research focus in the photovoltaic industry., Reducing the paste consumption to achieve cost reduction while ensuring the performance of the solar cells is the development trend of the photovoltaic industry.

In related technologies, a width and height of fingers are generally reduced to decrease the paste consumption. However, limited by a screen printing process, it is impossible to effectively achieve finer fingers while maintaining good performance of an electrode. Moreover, the inventors found that reducing the height of the fingers will increase a contact resistivity at the fingers of the solar cell, which is not conducive to improving conversion efficiency of the solar cell. Additionally, it is also prone to lead to adverse issues such as soldering-induced finger breakage of the solar cell, thereby resulting in failure to meet soldering requirements of the electrode.

Specifically, steel-wire mesh screens in related technologies have limitations in reducing an opening width of a membrane layer. Even if the opening is designed with a narrow line width, in practice, the interweaving of steel-wire meshes may cause paste blockage, thereby affecting the discharge of paste, thereby affecting the printed fingers, and thus failing to truly achieve fine fingers. Meanwhile, attempting to reduce a height of the fingers to reduce the overall silver paste consumption also brings issues. That is, a finger height may not meet the requirements for welding. When soldering solder ribbons, due to an excessively-low height of the fingers to be soldered, during the reaction between a tin-based alloy on a surface of the solder ribbons and silver fingers, a silver content in silver fingers is insufficient to meet the requirements for full soldering of the solder ribbons. This leads to problems such as finger breakage at the soldering locations, and thus affecting the current collection capability of the solder ribbons. Moreover, the excessively-low height of the fingers results in a smaller cross-sectional area of the fingers, which leads to a higher contact resistivity, thereby affecting a conversion efficiency of the solar cells, and thus failing to achieve a high efficiency and a low cost.

Based on the above, the present application discloses a solar cell, a screen printing plate structure, and a photovoltaic module, where a first electrode includes a plurality of first fingers and a plurality of first connecting portions, and a portion of the first connecting portions are configured to be soldered with solder ribbons. A maximum height H1 of the first connecting portion satisfies: 4 µm ≤ H1 ≤ 10 µm. By setting the maximum height of the first connecting portion of the first electrode within a reasonable range, it not only helps reduce the occurrence likelihood of adverse issues such as soldering-induced finger breakage, but also the appropriate height range may facilitate to avoid obtaining an excessively-high contact resistivity between the first finger and the first connecting portion, thereby being more conducive to improving the conversion efficiency of the solar cells. Meanwhile, by controlling the maximum height of the first connecting portion within an optimal height range, the paste consumption for printing the first connecting portion may be reduced, thereby facilitating better control the production cost of the solar cells.

The technical solutions of the present application will be illustrated below accompanying embodiments and with reference to the drawings.

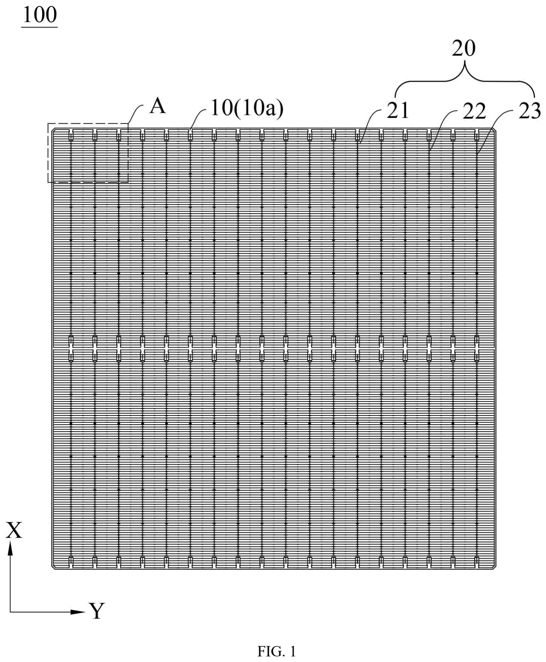

In a first aspect, referring to FIG. 1 to FIG. 4, an embodiment of the present application discloses a solar cell 100, the solar cell 100 includes a half-finished solar cell 10, and the half-finished solar cell 10 has a front surface 10a and a rear surface 10b arranged opposite to each other. Among them, the front surface 10a of the half-finished solar cell 10 is a front side, and the rear surface 10b of the half-finished solar cell 10 is a rear side.

It should be noted that the half-finished solar cell 10 may refer to a half-finished structure of the solar cell 100 before an electrode is printed. For example, the solar cell half-finished product 10 may include a silicon substrate, a front surface passivation layer and a front surface anti-reflection layer sequentially formed on a front surface of the silicon substrate, and a rear surface passivation layer and a rear surface anti-reflection layer sequentially formed on a rear surface of the silicon substrate.

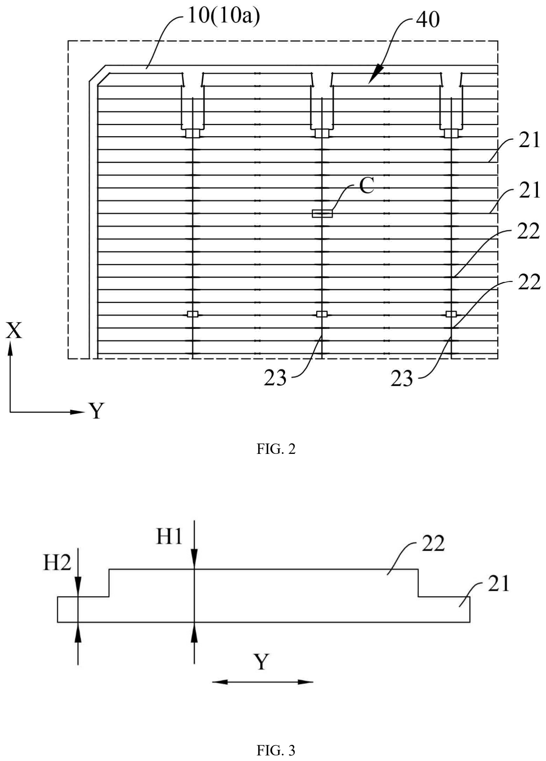

In some implementations, referring to FIG. 1 and FIG. 2, the solar cell 100 includes a first electrode 20, and the first electrode 20 is disposed on the half-finished solar cell 10. The first electrode 20 includes a plurality of first fingers 21 and a plurality of first connecting portions 22, the plurality of first fingers 21 are arranged at intervals along a first direction X, and each of the first fingers 21 extends along a second direction Y. The plurality of first connecting portions 22 are arranged at intervals along the first direction X, the first connecting portion 22 is connected to the first finger 21, and a portion of the first connecting portions 22 are configured to be soldered to solder ribbons (not shown in the figures).

In an embodiment of the present application, the first direction X intersects with the second direction Y, for example, the first direction X is perpendicular or approximately perpendicular to the second direction Y. For example, the first direction X may be a longitudinal direction, and the second direction Y may be a transverse direction. The plurality of first fingers 21 are arranged at intervals along the longitudinal direction, and each first finger 21 extends along the transverse direction. Among them, the plurality of first fingers 21 are parallel or approximately parallel to each other. It may be understood that, in the actual preparation process of the solar cell 100, factors such as an equipment machining accuracy and a measurement error may affect an actual formation of the fingers, thereby making the fingers approximately parallel to each other.

Since a tin-based alloy on a surface of the solder ribbons will react with the first connecting portion 22 during soldered, the tin-based alloy will etch away a certain amount of conductive metal material in the first connecting portion 22, so that a conductive metal-tin-based alloy system is formed. In a case that a height of the conductive metal material in the first connecting portion 22 is too low, it may not provide a sufficient amount of the conductive metal material for the conductive metal-tin-based alloy system that is to be formed during soldering, thereby resulting in the current collected by the solar cell through the first finger 21 being unable to be transported out through the solder ribbons, that is, an unexpected finger breakage is formed between the first finger 21 and the solder ribbons.

Among them, a purpose of the conductive metal in the first connecting portion 22 is to transport the current and form a conductive interconnection between the fingers, the busbars and the solder ribbons. Therefore, the conductive metal used for forming the first connecting portion 22 in the present application is not limited to common silver paste, silver-aluminum paste, aluminum paste, electroplated copper or silver-coated copper paste.

Based on this, in some embodiments, a maximum height H1 of the first connecting portion 22 satisfies: 4 µm ≤ H1 ≤ 10 µm. Optionally, the maximum height H1 of the first connecting portion 22 may satisfy: 4 µm ≤ H1 ≤ 5 µm, 5 µm ≤ H1 ≤ 6 µm, 6 µm ≤ H1 ≤ 7 µm, 6 µm ≤ H1 ≤ 8 µm, 7 µm ≤ H1 ≤ 8 µm, or 7 µm ≤ H1 ≤ 10 µm and so on. For example, H1 may be 6 µm, 7 µm, 8 µm, 9 µm, or 10 µm, and so on.

By setting the maximum height H1 of the first connecting portion 22 within the above range, the occurrence likelihood of adverse problems such as soldering-induced finger breakage is reduced. Moreover, a reasonable height range may avoid the excessively-high contact resistivity between the first finger 21 and the first connecting portion 22, thereby being more conducive to improving the conversion efficiency of the solar cell 100, and enhancing the reliability of the photovoltaic module.

At the same time, by controlling the maximum height of the first connecting portion 22 within an optimal height range, the paste consumption for printing the first connecting portion 22 is reduced, thus facilitating better control of the production cost of the solar cell 100.

If the maximum height H1 of the first connecting portion 22 is less than 4 µm, the maximum height H1 of the first connecting portion 22 is too small. When the solder ribbons are soldered to the first connecting portion 22, the tin-based alloy in the solder ribbons will react with the first connecting portion 22 to cause silver to be etched off. The excessively low height of the first connecting portion 22 may not meet the conduction requirements and soldering reliability requirements for soldering, so that resulting in soldering joint breakage between the solder ribbons and the first connecting portion 22, thereby preventing current transportation, and thus causing serious defects in the solar cell 100. If the maximum height H1 of the first connecting portion 22 is greater than 10 µm, the maximum height H1 of the first connecting portion 22 is too large. In this case, although height requirements for soldering is met and the risk of the finger breakage is reduced, it will increase the paste consumption for printing, which is not conducive to controlling the production cost of the solar cell 100.

The maximum height of the first connection parts 22 in the present application may be defined as follows: a height profile of the first connecting portion 22 is obtained by a 3D microscope, along an extension direction of the first connecting portion 22, an appropriate area of the first connecting portion 22 is taken as a baseline of the height profile, a height of the baseline is measured, and then height point values of the baseline are extracted. For example, 1024 height point values are extracted in the present application. Subsequently, data treatment is performed on the 1024 height point values and abnormal value points are removed, the top 100 largest height point values in the remaining height point values are selected for calculating an average value thereof, which is defined as the maximum height of the first connecting portion 22 in the present application. Among them, the abnormal data point is defined as height data point values that exceeds the average value of the height point values by 30%, for example, assuming the average value of the 1024 height point values is Xave, and an abnormal data point is Xi, when |Xi-Xave|/Xave > 30%, the height data point value is the abnormal height point value described in the present application. If a length of the first connecting portion 22 is too long under a magnification of the microscope, the height point values of the first connecting portion 22 may only be measured on either side of the busbar. It should be noted that the number of the extracted height point values varies depending on a built-in software used for extracting the height point values.

It may be understood that the solar cell 100 in the embodiments of the present application may be zero busbar (0BB, without continuously-extending busbars). When the solar cell 100 is 0BB, the busbar or a pad on the busbar is eliminated, the first connecting portion 22 is soldered with the solder ribbons, and current is directly collected and conducted through the solder ribbons. In this way, the paste consumption for the busbar on the surface of the half-finished solar cell 10 may be significantly reduced, thereby achieving cost reduction.

Of course, in other embodiments, the solar cell 100 of the present application may also be multi busbars (MBB, with a plurality of continuously-extending busbars), super multi busbars (SMBB, with multiple busbars exceeding the MBB's busbars), and so on.

In some implementations, with reference to FIG. 2, the first electrode 20 also includes a plurality of first busbars 23, the plurality of first busbars 23 are arranged at intervals along the second direction Y, each of the first busbars 23 extends along the first direction X, and the first busbar 23 intersects with the first connecting portion 22. That is, the first connecting portion 22 is located at an intersection of the first busbar 23 and the first finger 21.

By setting the first busbar 23 on the half-finished solar cell 10, so that the current collected by the first finger 21 is concentrated onto the first busbar 23 and then exported out via the first connecting portion 22 being soldered to the solder ribbons, thereby effectively ensuring an sufficiently large soldering area between the solder ribbons and the first busbar 23, and/or between the solder ribbons and the pads located on the first busbar 23 through the first connecting portion 22, thereby improving the pull-off force requirement of the solder ribbons.

In some implementations, the maximum height H1 of the first connecting portion is greater than a maximum height of the first busbar 23 that is connected to the corresponding first connecting portion 22. By setting the maximum height H1 of the first connecting portion 22 to be greater than the maximum height of the first busbar 23 in a corresponding area of the first connecting portion 22, the current is transported via the soler ribbons, enabling a reduced paste consumption for printing the first busbar, and thus facilitate to achieve the reduction of production costs.

It should be noted that the maximum height of the first busbar 23 in the present application may refer to the above definition of the maximum height of the first connecting portion 22. However, considering the design of the screen printing plate in the present application, the height, of the corresponding busbar at an area where the first finger 21 intersects with the first busbar 23, is increased due to the presence of a thickened portion 202 in the area. Therefore, the area used for measuring the maximum height of the first busbar 23 in the present application is defined as an area of a busbar that is not covered by busbar connection line 221. Moreover, considering that the designed width of the busbar is usually less than the height of the first connecting portion 22, the busbar-disposed area, which corresponds to the maximum height measurement area of the first connecting portion 22, may be selected as a measurement area for the height profile; and the area, where a maximum height distribution of the first busbar 23 is disposed, may be selected along a direction parallel to the extension direction of the busbar as the profile baseline for measurement.

Optionally, the number of the first busbar 23 may ranges from 16 to 26. For example, the number of the first busbar 23 is 16, 18, 22, or 24, and so on. In this way, a greater number of first busbars 23 with smaller spacing may be obtained, so that a distance of the first finger 21 between two adjacent first busbars 23 is shortened, thereby reducing a transportation resistance of the finger and reducing a series resistance, and thus it is conducive to the improvement of the photoelectric conversion efficiency.

In some implementations, referring to FIG. 3, which shows a schematic cross-sectional structural diagram of the first connecting portion 22 and the first finger 21 connected to the first connecting portion 22. A maximum height of the first finger 21, which is connected to the first connecting portion 22, is H2, satisfying H1 ≥ 1.2H2~3H2. In other words, the maximum height of the first connecting portion 22 may be 1.2 to 3 times the maximum height of the first finger 21 connected thereto, or the maximum height of the first connecting portion 22 may be greater than 1.2 to 3 times the maximum height of the first finger 21 connected thereto.

Optionally, H1 and H2 may satisfy: H1 ≥ 1.2H2, H1 ≥ 1.5H2, H1 ≥ 2H2, or H1 ≥ 3H2, and so on. For example, it may be H1 = 1.5H2, H1 = 2H2, H1 = 2.5H2, or H1 = 3H2, and so on.

By setting the maximum height of the first connecting portion 22 to be greater than or equal to the maximum height of the first finger 21 connected thereto, that is, a height of the soldering area of the first electrode 20 is appropriately increased, so that of the first finger 21 has a relatively low height and the soldering area showing a relatively high height. This configuration reduces the risk of soldering-induced finger breakage due to an excessively-low height of the soldering area in soldering. Consequently, the production defect rate of the solar cell 100 is reduced. At the same time, by controlling the maximum height of the first finger 21 within a reasonable height range, the reduction of paste consumption may also be achieved, and thus it is beneficial to reduce the production costs of the solar cell 100.

The solar cell 100 of the present application serves as an experimental group, and the solar cell in the related technologies serves as a comparative group. Parameters in table 1 are obtained mainly by measuring a height of a busbar and a height of a finger, by calculating a height difference between the busbar and the finger correspondingly, and by measuring a conversion efficiency of a solar cell as well.

**Table 1**

| Group | Busbar Height | Finger Height | Height Difference | Conversion Efficiency |
|---|---|---|---|---|
| Comparative Group (Steel-Wire Mesh Screen) | 3.236 µm | 8.933 µm | 5.697 µm | 26.495% |
| Experimental Group (Steel-Plate Mesh screen) | 3.367 µm | 6.372 µm | 3.005 µm | 26.504% |

According to the test data in table 1, under the condition that the finger height is reduced, the solar cell in the embodiment of the present application still maintains a conversion efficiency that is essentially equivalent to a conversion efficiency of the solar cell in the related technologies. That is, the solar cell of the present application may reduce the paste consumption by controlling the height of the finger within a reasonable range, thereby achieving cost reduction while avoiding an unexpected excessively-large contact resistance which is caused by reducing the height of the fingers, where the reduced height of the fingers signifies a reduction of the conversion efficiency. Meanwhile, since the experimental group adopts the steel-plate mesh screen to print the finger, it may form fingers with a smaller smoothness factor, thereby providing a lower resistance transportation-loss for current transportation. It may be seen that the solar cell 100 in the embodiments of the present application may achieve the cost reduction by balancing off a smoother finger and a lower finger height.

It is worth noting that, the first electrode 20 includes a plurality of first fingers 21 and a plurality of first connecting portions 22, where the first finger 21 corresponds to the first connecting portion 22, that is, each first finger 21 is correspondingly provided with a plurality of first connecting portions 22, and the first connecting portions 22 are arranged at intervals along the second direction Y. Then, the above H1 refers to: the maximum height of the first connecting portion 22 to be connected to the first finger 21; and the above H2 refers to: the maximum height of each first finger 21. Among them, a section of the first finger 21 close to the first connecting portion 22 may be selected as a selection area for measuring the maximum height H2 of the first finger 21 to be connected to the first connecting portion 22. The height profile of the first finger 21 is obtained by performing a 3D microscope, along the extension direction of the first finger 21, an appropriate area of the first finger 21 is taken as the reference baseline for measuring the height profile, with height values of the baseline extracted. For example, 1024 height values are extracted in the present application. Subsequently, data treatment is performed on the 1024 height values to remove abnormal values, the top 100 largest values are selected from the remaining values for calculating an average value, which is the maximum height H2 of the first finger 21. Among them, the abnormal data is defined as height data values that exceeds the average value of the height point values by 30%. For example: assuming the average value of 1024 height point values is Xave, and an abnormal data point is Xi, when |Xi-Xave|/Xave > 30%, the height value is the abnormal height described in the present application.

In some implementations, a difference between H1 and H2 ranges from 1 µm to 4 µm. Optionally, a height difference between H1 and H2 may be 1 µm to 3 µm, 1 µm to 2 µm, 2 µm to 4 µm, or 2 µm to 3 µm, and so on. For example, the height difference between H1 and H2 may be 1 µm, 2 µm, 3 µm, or 4 µm, and so on.

By controlling the maximum height of the first connecting portion 22 to be greater than the maximum height of the first finger 21, and by controlling the height difference between them to be in a reasonable range, the soldering performance is ensured, the paste consumption is reduced as well, and an excessively-large height difference, between the first connecting portion 22 and the first finger 21, is avoided, thereby preventing the problem of soldering-induced breakage due to the excessively-large height difference.

If the height difference between H1 and H2 is less than 1 µm, the height difference between H1 and H2 is not significant. Since it is necessary for the first connecting portion 22 to reach a certain maximum height H1 to avoid the problem of soldering-induced finger breakage, which implies an increase of the paste for printing the first finger 21, and thus unable to reduce the paste consumption. If the height difference between H1 and H2 is greater than 4 µm, it indicates that the height of the first finger 21 is relatively low, and the low height of the first finger 21 indicates that the first finger 21 used for collecting the current has a higher resistivity, thereby failing to meet the current industrialization requirements of a higher conversion efficiency of the solar cell 100. In addition, it may not be able to meet the requirements for obtaining high-conversion-efficiency solar cells through interweaved screen. That is to say, to achieve a lower printing height of the first finger, a thickness of the mesh screen should be reduced, but the excessively low mesh-screen thickness may not be achieved by the current industrial engineering.

In some embodiments, a maximum height H2 of the first finger 21 connected to the first connecting portion 22 satisfies: 4 µm ≤ H2 ≤ 6 µm. Optionally, the height H2 of the first finger 21 connected to the first connecting portion 22 may satisfy: 4 µm < H2 ≤ 5 µm, 5 µm ≤ H2 ≤ 6 µm, or 4.5 µm ≤ H2 ≤ 5.5 µm, and so on. For example, H2 may be 4 µm, 5 µm, or 6 µm, and so on.

By limiting the maximum height H2 of the first finger 21 within a reasonable range to create a height difference with the first connecting portion 22, so that the overall paste consumption is reduced by decreasing the height of the first fingers 21 without introducing the issue of increased soldering defect rate associated with such a reduction. Consequently, the solar cell may comprehensively meet the market demand for high efficiency and low cost. In addition, by controlling the maximum height of the first finger 21 within a reasonable range, the first finger 21 will have better current transportation capability. If the height of the first finger 21 is too low, a contact resistance and line resistance of the first finger 21 increase, and the current transportation loss of the solar cell100 is ultimately increased. Moreover, if the printing height of the first fingers 21 is excessively low, it cannot be achieved through screen printing. Specifically, to achieve a lower printing height of the first finger, the thickness of the screen printing plate must be reduced. However, an excessively low screen printing plate printing thickness may exceed the capabilities of current manufacturing processes. If the maximum height of the first finger 21 is too high, it will increase the paste consumption for printing the first finger, which is not conducive to controlling the production costs. Moreover, due to the fluidity of the paste, the printed fingers will diffuse into a normal light area of the solar cell, thereby reducing an effective area of the solar cell for generating photocurrent, and thus reducing the conversion efficiency of the solar cell.

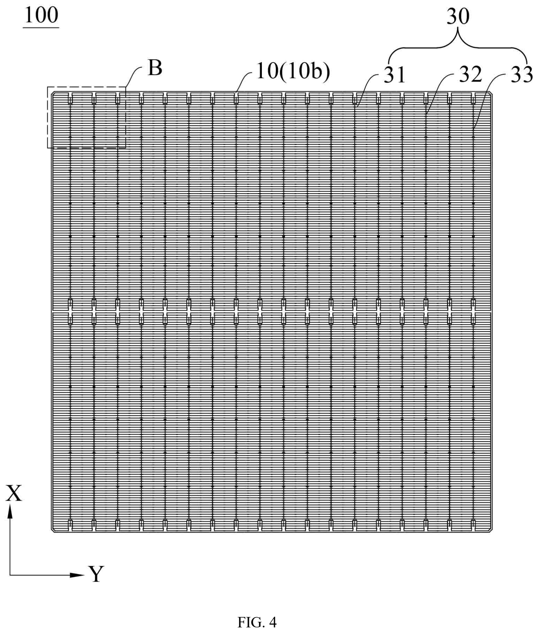

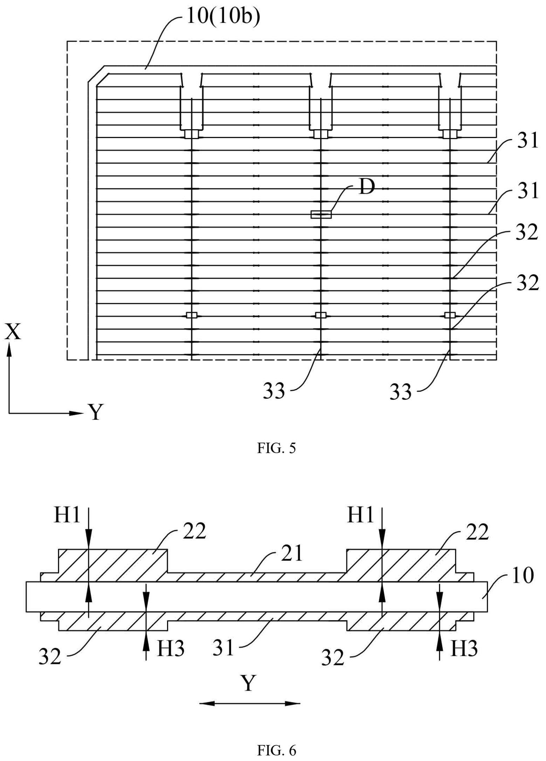

In some implementations, referring to FIG. 4 and FIG. 5, the solar cell 100 includes a second electrode 30. The second electrode 30 is disposed on the half-finished solar cell 10, and the second electrode 30 includes a plurality of second fingers 31 and a plurality of second connecting portions 32. The plurality of second fingers 31 are arranged at intervals along the first direction X, each of the second fingers 31 extends along the second direction Y, the plurality of second connecting portions 32 are arranged at intervals along the first direction X, the second connecting portion 32 is connected to the second finger 31, and a portion of the second connecting portions 32 are configured to be soldered with the solder ribbons.

Optionally, the plurality of second fingers 31 may also be arranged at intervals along the longitudinal direction, and each second finger 31 extends along the transverse direction.

In some implementations, the second electrode 30 may also include a plurality of second busbars 33, the plurality of second busbars 33 are arranged at intervals along the second direction Y, each of the second busbars 33 extends along the first direction X, and the second busbar 33 intersects with the second connecting portion 32. That is to say, the second connecting portion 32 is located at the intersection of the second busbar 33 and the second finger 31. The specific arrangement may refer to the arrangement of the first busbar 23 in the first electrode 20, which will not be repeated herein.

In some implementations, the polarity of the first electrode 20 is opposite to that of the second electrode 30 are opposite. For example, the first electrode 20 may be a positive electrode, and the second electrode 30 may be a negative electrode; or, the first electrode 20 may be the negative electrode, and the second electrode 30 may be the positive electrode.

Optionally, the first electrode 20 is arranged on the front surface 10a of the half-finished solar cell 10, and the second electrode30 is arranged on the rear surface 10b of the half-finished solar cell 10; or, in a back-contact solar cell, the first electrode 20 and the second electrode 30 are both disposed on the rear surface 10b of the half-finished solar cell 10.

It may be understood that, the solar cell 100, with the first electrode 20 disposed on the front surface 10a of the half-finished solar cell 10 and the second electrode 30 disposed on the rear surface 10b of the half-finished solar cell 10, may be a passivated contact cell. The solar cell 100, with both the first electrode 20 and the second electrode 30 disposed on the rear surface 10b of the half-finished solar cell 10, may be a back-contact cell, that is, there is no light shading from the front surface fingers, thereby eliminating current loss due to shading.

The embodiments of the present application will be described with the first electrode 20 disposed on the front surface 10a of the half-finished solar cell 10 and the second electrode 30 disposed on the rear surface 10b of the half-finished solar cell 10 as an example.

It should be noted that in actual production, the inventors found that when the first electrode 20 is disposed on the front surface 10a of the half-finished solar cell 10 and the second electrode 30 is disposed on the rear surface 10b of the half-finished solar cell 10, a glass content in the paste for printing the busbars of the first electrode and the second electrode is usually the same, while a glass content in the paste for printing the second finger 31 on the rear surface 10b is usually greater than a glass content in the paste for printing the first finger 21 on the front surface 10a, in other words, a glass powder content in the paste for printing the first connecting portion 22 is configured to be less than a glass powder content in the paste for printing the second connecting portion 32.

The inventors found through research that the glass content in the paste for printing the finger on the rear surface of the solar cell is higher than the glass powder content in the paste for printing the finger on the front surface, and the glass powder may hinder the reaction between the tin-based alloy in the solder ribbons and the silver in the fingers, thereby hindering the finger from being broken.

In some implementations, a maximum height of the second connecting portion 32 is H3, and H1 > H3. That is, the maximum height of the first connecting portion 22 is greater than the maximum height of the second connecting portion 32.

It should be noted that since the solar cell 100 has the plurality of first connecting portions 22 and the plurality of second connecting portions 32, the maximum height of the aforementioned first connecting portion 22 is greater than the maximum height of the second connecting portion 32 may refer to: the maximum height of any first connecting portion 22 in the first electrode 20 may be greater than the maximum height of any second connecting portion 32 in the second electrode 30.

Referring to FIG. 6, which shows a schematic cross-sectional structural diagram of the first connecting portion 22 and the second connecting portion 32 with the first electrode 20 and the second electrode 30 respectively disposed on the front and rear surfaces of the half-finished solar cell 10. In this figure, two sets of first connecting portions 22 and second connecting portions 32 disposed opposite to each other in a thickness direction of the half-finished solar cell 10 are shown, where H1>H3 may refer to: a relationship between the maximum heights of a corresponding set of the first connecting portion 22 and the second connecting portion 32 ( the upper and lower corresponding relationship as shown in the plane of FIG. 6), or it may refer to: a relationship between the maximum height of the first connecting portion 22 in one set and the maximum height of the second connecting portion 32 in another set (cross-corresponding relationship as shown in the plane of FIG. 6).

Furthermore, the maximum height H1 of the first connecting portion 22 and the maximum height H3 of the second connecting portion 32 may satisfy: H1 ≥ 1.2H3, H1 ≥ 1.4H3, H1 ≥ 1.5H3, or H1 ≥ 1.75H3, and so on. For example, H1 = 1.2H3, H1=1.4H3, H1=1.5H3, or H1 = 1.75H3, and so on. For example, when the maximum height H1 of the first connecting portion 22 is 6 µm, the maximum height H3 of the second connecting portion 32 is 4 µm; and when the maximum height H1 of the first connecting portion 22 is 7 µm, the maximum height H3 of the second connecting portion 32 is 5 µm, and so on.

Since the glass content in the paste for printing the second finger 31 on the rear surface 10b is usually greater than the glass content in the paste for printing the first finger 21 printed on the front surface 10a, in the present application, the height of the first connecting portion 22 of the first electrode 20 is set to be greater than the maximum height of the second connecting portion 32 of the second electrode 30. Since a higher content of glass powder may hinder the second finger 31 of the second connecting portion 32 from being broken due to the silver etching reaction of the tin-based alloy on the surface of the solder ribbons during soldering, so that the connection portion may still be well soldered after the silver etching reaction with the solder ribbons, thereby effectively ensuring that the current collected by the second finger 31 is transported to the solder ribbons, and thus reducing the defect rate of the solar cell 100 and reducing the paste consumption when printing the second connecting portion 32 of the second electrode 30. Consequently, according to the present application, by using the paste with a higher glass content, the second finger 31 of the second connecting portion 32 is prevented from being broken during soldering. In this way, the height of the second connecting portion 32 of the second electrode 30 may be set to be lower than the height of the first connecting portion 22 of the first electrode 20, which may meet the soldering performance while saving the paste consumption, and thus reducing production costs.

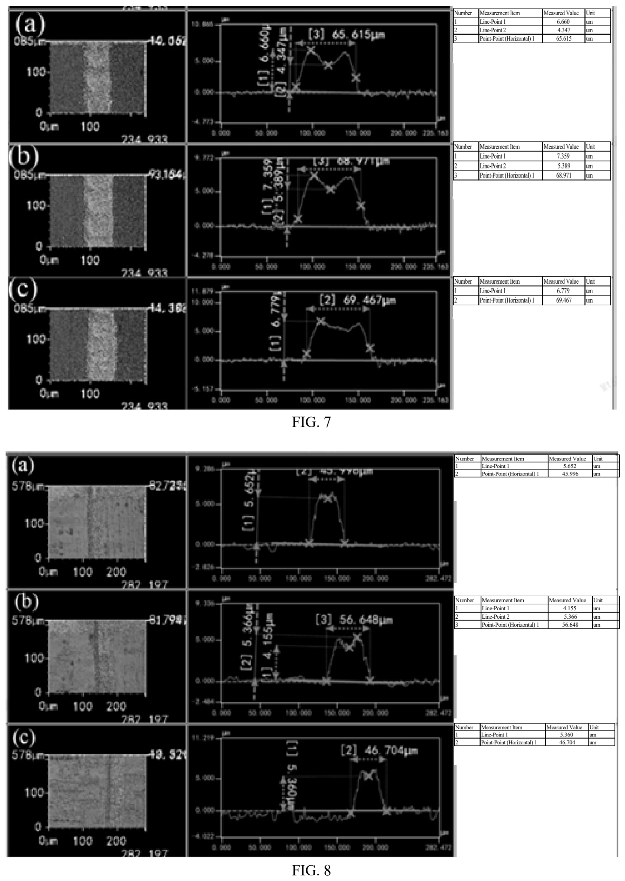

It should be noted that the maximum height in the present application, for example, the maximum height of the second connecting portion, the maximum height of the first finger, and so on, may refer to the definition of the maximum height of the first connecting portion 22 in the present application. Regarding the selection of an appropriate area for a baseline of the height profile, referring to FIG. 8, when a morphology of the first connecting portion is a bimodal M-type, a peak with a higher height may be selected as the baseline for selecting the height profile as shown by the 3D microscope. When a morphology of the first connecting portion is a single-peak Gaussian curve, a peak with the highest height is taken as the baseline for selecting the height profile.

In some implementations, the maximum height H3 of the second connecting portion 32 satisfies: 4 µm≤ H3 ≤8 µm. Optionally, the maximum height H3 of the second connecting portion 32 may satisfy: 4 µm ≤ H3 ≤ 6 µm, 4 µm ≤ H3 ≤5 µm, 5 µm ≤ H3 ≤ 6 µm, 6 µm ≤ H3 ≤ 8 µm, or 7 µm ≤ H3 ≤ 8 µm, and so on. For example, H3 may be 4 µm, 5 µm, 6 µm, 7 µm, or 8 µm, and so on.

Since the glass content in the paste for printing the second finger 31 on the rear surface 10b is usually greater than the glass powder content in the paste for printing the first finger 21 on the front surface 10a, and the inventors found that the glass powder may prevent the molten tin-based alloy in the solder ribbons from diffusing and reacting with silver, while a higher glass powder content may prevent the fingers from being broken due to the silver etching reaction between the molten tin-based alloy in the solder ribbons and the fingers at the connection portions during soldering. Therefore, by making the maximum height H3 of the second connecting portion 32 satisfy the above relationship in the present application, it is ensured that the second connecting portion 32 of the second electrode 30 meets the height requirements for soldering while reducing the paste consumption, and thus reducing the production costs. That is, since the second connecting portion 32 of the second electrode 30 has a higher content of glass powder, the height of the second connecting portion 32 does not need to be set to high to meet the soldering requirements, thereby saving the paste consumption, and thus better controlling the production cost of the solar cell.

The following provides a comparative description of the heights of the first connecting portion 22 of the first electrode 20 and the second connecting portion 32 of the second electrode 30 in the present application.

Refer to FIG. 7 and FIG. 8, FIG. 7 shows a cross-sectional profile diagram of the first connecting portion 22 of the first electrode 20 at different positions, and FIG. 8 shows a cross-sectional profile diagram of the second connecting portion 32 of the second electrode 30 at different positions. The cross-sectional profile diagrams may refer to: a cross-section taken along a plane parallel to the first direction.

Referring to table 2, which shows height comparison data obtained from three different positions of the first connecting portion 22 and the second connecting portion 32 respectively.

**Table 2**

| Selecting Position | 1 | 2 | 3 |
|---|---|---|---|
| Maximum Height H1 of First Connecting Portion (µm) | 6.660 | 7.359 | 6.779 |
| Maximum Height H3 of Second Connecting Portion (µm) | 5.652 | 5.366 | 5.360 |

Among them, the maximum heights obtained at three different positions of the first connecting portion 22 of the first electrode 20 are 6.660 µm, 7.359 µm, and 6.779 µm, respectively, and the maximum heights obtained at three different positions of the second connecting portion 32 of the second electrode 30 are 5.652 µm, 5.366 µm, and 5.360 µm, respectively. It may be seen that the maximum height of the first connecting portion 22 of the first electrode 20 is greater than the height of the second connecting portion 32 of the second electrode 30.

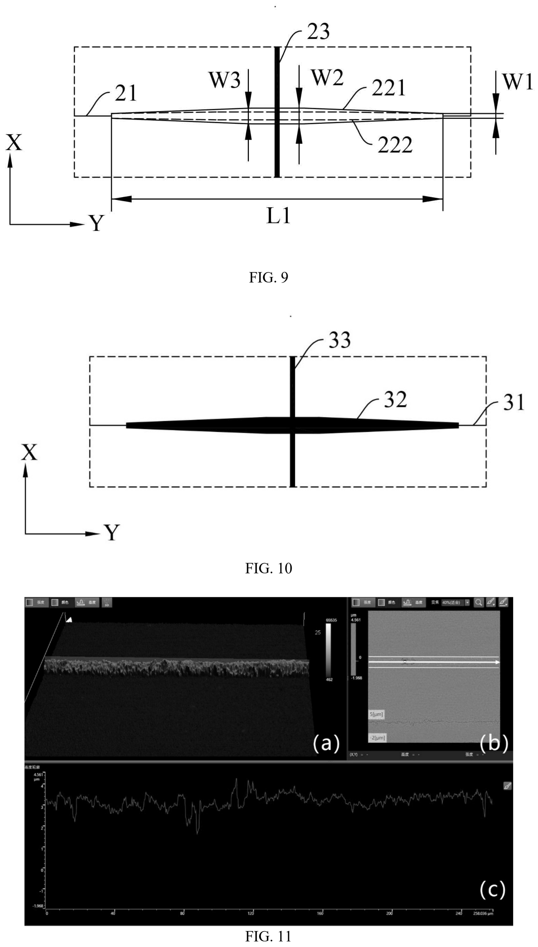

In some implementations, referring to FIG. 9, the first connecting portion 22 includes a finger connection line 222 and a busbar connection line 221, and at least a portion of the finger connection line 222 overlaps with the busbar connection line 221. Among them, the finger connection line 222 may refer to the dashed portion in FIG. 9, and the busbar connection line 221 may refer to the solid line portion in FIG. 9.

It may be understood that the first connecting portion 22 may be formed by two printing processes. During printing, the finger connection line 222 and the busbar connection line 221 are arranged to at least partially overlap to compensate the height of the soldering area, thereby achieving good soldering and matching between the solder ribbons and the electrode fingers, and thus reducing the risk of finger breakage due to a low soldering area height to ensure the smoothness of the current transportation circuit. Among them, the two printing processes for preparing the first connecting portion 22 refer to: both a finger screen printing plate and a busbar screen printing plate have corresponding printing areas of the first connecting portion 22, thereby achieving the thickened design of the maximum height of the first connecting portion 22 through the two printing processes.

Optionally, the busbar connection line 221 may be printed together with the first busbar 23, and the finger connection line 222 may be printed together with the first finger 21.

For example, the busbar connection line 221 may be printed first on the half-finished solar cell 10, at this point, the height of the busbar connection line 221 may be about 3 µm to 4 µm. Then the finger pattern is printed on the half-finished solar cell 10, so that a total height of the first connecting portion 22, after stacking the finger connection line 222, is about 7 µm to 8 µm, to meet the soldering requirements.

In some implementations, a corresponding region between the busbar connection line 221 and the half-finished solar cell 10 has a silicon-containing dielectric layer. It is understood that the corresponding region between the busbar connection line 221 and the half-finished solar cell 10 has the silicon-containing dielectric layer, that is, the busbar connection line 221 does not burn through the silicon nitride on the surface of the half-finished solar cell 10, and the paste for printing the busbar connection line 221 adopts a non-burn-through conductive paste (for example, silver paste without or with a low content of glass powder). Since a corrosion degree of the non-burn-through conductive paste is low, it will not damage a silicon nitride film layer on the surface of the half-finished solar cell 10, thereby reducing damage to a PN junction of the solar cell 100.

In some implementations, continuing to refer to FIG. 9, the busbar connection line 221 is covered by the finger connection line 222. That is, a projection of the finger connection line 222 on the half-finished solar cell 10 falls within a projection of the busbar connection line 221 on the half-finished solar cell 10, and an overall size of the busbar connection line 221 is greater than an overall size of the finger connection line 222.

By setting the busbar connection line 221 to be covered by finger connection line 222, on one hand, an overlapping area forms the first connecting portion 22 is greater, that is, a greater soldering area has a greater height, which is more benefit to meeting the soldering requirements.

Certainly, in some other implementations, the finger connection line 222 may covers the busbar connection line 221, that is, the projection of the busbar connection line 221 on the half-finished solar cell 10 falls within the projection of the finger connection line 222 on the half-finished solar cell 10.

In some implementations, a total length of the busbar connection line 221 in the second direction Y is equal to a total length of the finger connection line 222 in the second direction Y; and/or, a minimum width of the busbar connection line 221 in the first direction X is equal to a minimum width of the finger connection line 222 in the first direction X.

On the basis that the overall size of the busbar connection line 221 is greater than the finger connection line 222, by further setting the total lengths of the busbar connection line 221 and the finger connection line 222 in the second direction Y to be equal and the minimum widths in the first direction X to be equal may maximize the overlapping area of the busbar connection line 221 and the finger connection line the 222. Even if there is a certain soldering deviation in the second direction Y during soldering of the solder ribbon, since the busbar connection line 221 and the finger connection line 222 have a higher overlapping height along the total length of the second direction Y, so that the soldering requirements is effectively met, thereby effectively preventing the occurrence of finger breakage phenomena due to the breakage of the first finger 21 caused by molten solder after soldering.

In some implementations, the total length L1 of the busbar connection line 221 and the finger connection line 222 in the second direction Y is 1 mm to 1.5 mm. Optionally, the total length L1 of the busbar connection line 221 and the finger connection line 222 in the second direction Y is 1 mm to 1.4 mm, 1 mm to 1.2 mm, or 1.2 mm to 1.5 mm, and so on. For example, L1 may be 1 mm, 1.2 mm, 1.3 mm, 1.4 mm, or 1.5 mm, and so on.

It is understandable that the total lengths of the busbar connection line 221 and the finger connection line 222 in the second direction Y may be equal, or the total length of the busbar connection line 221 in the second direction Y may be greater than the total length of the finger connection line 222 in the second direction Y. For example, the total length of the busbar connection line 221 in the second direction Y may be 1 mm, and the total length of the finger connection line 222 in the second direction Y may also be 1 mm; or, the total length of the busbar connection line 221 in the second direction Y may be 1.5 mm, and the total length of the finger connection line 222 in the second direction Y may be 1 mm.

In some implementations, the minimum width W1 of the busbar connection line 221 and/or the finger connection line 222 in the first direction X ranges from 10 µm to 20 µm. Optionally, the minimum width W1 of the busbar connection line 221 and/or the finger connection line 222 in the first direction X may be 10 µm to 17 µm, 10 µm to 15 µm, 15 µm to 20 µm, or 12 µm to 15 µm, and so on. For example, W1 may be 10 µm, 13 µm, 15 µm, 17 µm, or 20 µm, and so on.

In some implementations, the maximum width W2 of the busbar connection line 221 in the first direction X ranges from 50 µm to 80 µm. Optionally, the maximum width W2 of the busbar connection line 221 in the first direction X may be range from 50 µm to 70µm, 50 µm to 60 µm, 60 µm to 80 µm, 70 µm to 80 µm, or 60 µm to 70 µm, and so on. For example, W2 may be 50 µm, 60 µm, 70 µm, or 80 µm, and so on.

In some implementations, the maximum width W3 of the finger connection line 222 in the first direction X ranges from 25 µm to 40 µm. Optionally, the maximum width W3 of the finger connection line 222 in the first direction X may be range from 25 µm to 35 µm, 25 µm to 30 µm, 30 µm to 40 µm, or 30 µm to 35 µm, and so on. For example, W3 may be 25 µm, 30 µm, 35 µm, or 40 µm, and so on.

By limiting the sizes of the busbar connection line 221 and the finger connection line 222 within a reasonable range, so that there is a sufficient soldering area for meeting the soldering requirements, thereby preventing the occurrence of finger breakage phenomena due to the breakage of the first finger 21 caused by the molten solder during soldering. Moreover, the paste consumption is reasonably allocated without excessively increasing a light shading area, thereby avoiding affecting the conversion efficiency of the solar cell 100.

It should be noted that the shapes of the busbar connection line 221 and the finger connection line 222 are roughly as follows: two ends in the second direction Y are trapezoidal, and the middle part is rectangular, that is, along the second direction, the width of the connecting portion in the first direction X gradually increases from both ends to the middle, and after increasing to the maximum height, it no longer changes. This configuration not only ensures the connection stability between the first finger 21 and the first busbar 23, which avoiding breakage, but also makes the first connecting portion 22 have a greater area to meet the soldering requirements, so that the current is more favorably collected, thereby allowing the conduction current to converge to the maximum to achieve reducing the conduction resistance, and thus facilitating effective contact and stable current transportation. At the same time, by setting the size of the busbar connection line 221 to cover the size of the finger connection line 222, it allows a certain amount of offset allowance when the finger connection line 222 falls within the range of the busbar connection line 221, thereby preventing the overall appearance of the first connecting portion 22 from being poor.

Optionally, referring to FIG. 10, the second connecting portion 32 may include a single layer, which may be formed simultaneously during printing the second finger 31.

In a second aspect, the present application also discloses a screen printing plate structure 200 applied to a solar cell 100. The solar cell 100 includes a half-finished solar cell 10. Through the screen printing plate structure 200, paste may be printed onto the surface of the half-finished solar cell 10 in a specific printing pattern through a printing process, and then it is sintered to form the aforementioned first electrode 20 and/or second electrode 30.

In related technologies, a steel-wire mesh screen is generally used for printing. Since the steel-wire mesh screen is formed by the cross-weaving of steel-wires with a certain count and diameter, and then based on the selective ink permeability principle of the formed printing opening, a screen printing plate with a specific pattern is made, and fixed pattern fingers are subsequently formed on the half-finished solar cell 10 through printing. Since the steel-wires are interwoven, the steel-wires are not on a same plane, and there is obstruction at the printing opening where the wires intersect, thereby making it difficult for the paste to pass through during printing, and thus resulting in a low transfer efficiency. Moreover, this leads to uneven printing of the paste, with issues such as broken grinders, rosin printing, and poor flatness. Furthermore, the higher the opening ratio of the mesh screen, the better the printability, accordingly, the finer the line. However, due to the presence of mesh knots in the steel-wire mesh screen, the flatness of the fingers is also restricted. In addition, even though a current screen printing plate without mesh knot is capable of placing the graphic openings between two parallel warp or weft lines to enhance the ink permeability thereof, there are still a large quantity of the warp or weft lines arranged in a width direction of the graphic openings. The lines arranged perpendicular to the graphic openings will still obstruct the flow of the silver paste for printing. Therefore, it causes the printed finger to exhibit fluctuations in height and depth, thereby increasing the resistivity of the printed electrode pattern, and thus reducing the effective utilization rate of the paste and adversely affecting the power generation efficiency of the solar cell.

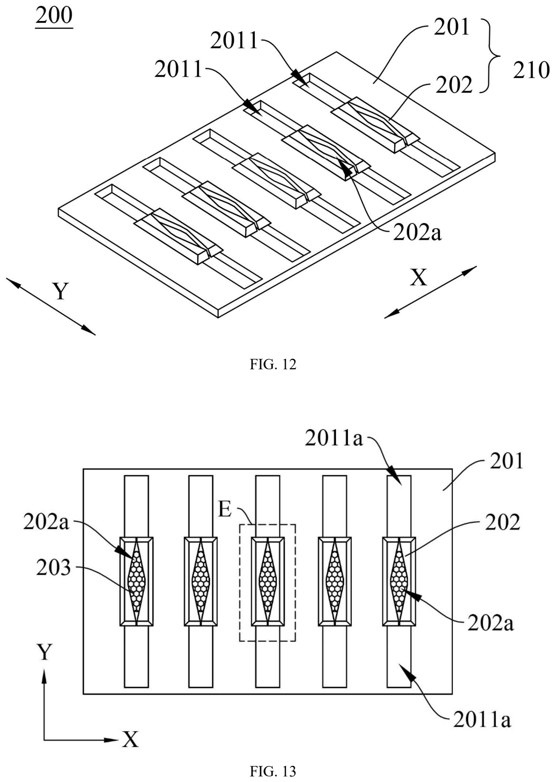

In some implementations, referring to FIG. 12, the screen printing plate structure 200 includes a substrate 210, and the screen printing plate structure 200 includes a main body portion 201 and a thickened portion 202. The thickened portion 202 is disposed on the main body portion 201 along the thickness direction of the main body portion 201. The main body portion 201 is provided with a plurality of first openings 2011 penetrating through the main body portion 201 in a thickness direction thereof. The plurality of first openings 2011 are arranged at intervals along a first direction X, and each first opening 2011 extends along a second direction Y. The first opening 2011 is configured to form a first finger 21 on the half-finished solar cell 10. The thickened portion 202 is provided with a second opening 202a extending along the second direction Y. The second opening 202a corresponds to at least one first opening 2011 and penetrates through the main body portion 201 in the thickness direction of the main body portion 201 to connect the first opening 2011. The second opening 202a is configured to form a first connecting portion 22 on the half-finished solar cell10, such that the first connecting portion 22 is connected to the first finger 21, and the first connecting portion 22 is configured to connect to solder ribbons. Among them, the first direction X intersects with the second direction Y.

By setting the thickened portion 202 on the screen printing plate structure for printing the first finger 21 and forming the second opening 202a for forming the first connecting portion 22 on the thickened portion 202, the printed area may obtain more paste to form the first connecting portion 22 having a higher height, thereby ensuring that the first connecting portion 22 meets the required soldering height to make the tin-based alloy on the surface of the solder ribbons do not completely etch away the silver in soldering area, thereby preventing the first finger 21 from being broken, and thus achieving good soldering performance of the electrode.

It should be noted that the first opening 2011 and the second opening 202a formed on the substrate 210 both have a high opening ratio of 80% to 100% (including the endpoints of 80% and 100%). Among them, an opening ratio of the first opening 2011 is greater than an opening ratio of the second opening 202a. When the first opening 2011 have an opening ratio of 100%, there is no obstruction to the paste passing through the first opening 2011. Compared to the related technologies where there are wires or mesh knots blocking the openings of the steel-wire mesh screen, the paste directly passes through the openings on the substrate 210 during printing, thereby making the infiltration process of the paste smoother and more uniform, and thus preventing printing defects such as finger breakage and rosin printing in the first finger 21. Moreover, it avoids the unevenness of the printed paste due to blocking, thereby enabling the printed fingers to be flatter. When the first opening 2011 has a high opening ratio of 95% to 100% (excluding the endpoint 100%), the first opening 2011 is provided with sparsely distributed steel-wires to enhance the mechanical support strength of the substrate. Compared to the first opening 2011 with a 100% opening ratio, although the sparsely distributed steel-wires will block the infiltration of the paste, which increases the unevenness of the fingers printed from the first opening 2011, the impact is negligible. Moreover, the sparsely distributed steel-wires may also increase the mechanical support strength of the substrate. Therefore, by adopting a screen printing plate with sparsely distributed steel-wires in the first opening 2011, the printed smoothness factor of the first finger 21 is smaller than the smoothness factor of the first connecting portion 22.

It should be noted that, specifically, referring to FIG. 11, the height profile of the first finger 21 is measured by performing a 3D microscope at a magnification of 50x or other suitable magnifications, and based on the height profile, a height curve is obtained, and height values are then derived from the height curve, such as 1024 height point values are exported out in the present application, and a variance in mathematical statistics is calculated from the 1024 height point values. The variance is used for representing a fluctuation amplitude of the height of the first finger 21, which is the smoothness factor described in the present application. It should be noted that, depending on the system settings of different models of 3D microscopes, any quantity of height point values may be exported out. To reduce the error of the calculation of the smoothing factor caused by abnormal points, abnormal height points are eliminated in the present application, where the abnormal points are defined as height point values that exceed 30% of the average value of all height point values. For example, assuming the average value of the 1024 height point values is Xave, and an abnormal point is Xi, and when |Xi-Xave|/ Xave > 30%, the height data point values is the abnormal height point values described in the present application.

Optionally, the substrate 210 may be a metal or a polymer material substrate 210 or a base plate. When the substrate 210 is a metal substrate 210, it may be, for example, a steel-plate (for example, a stainless-steel-plate) or a copper plate, or a nickel-cobalt-iron alloy plate. When the substrate 210 is the polymer material substrate 210, it may be, for example, a polyimide (PI) plate or a nylon-based plate.

Optionally, the screen printing plate structure 200 may also include a frame. The frame may be connected to the periphery of the substrate 210 to fix the substrate 210.

In some implementations, referring to FIG. 12 and FIG. 13, each first opening 2011 includes a plurality of sub-openings 2011a. The plurality of sub-openings 2011a are arranged at intervals along the second direction Y. The thickened portion 202 is located between at least two adjacent sub-openings 2011a, and the second opening 202a is connected to two adjacent sub-openings 2011a. By setting the thickened portion 202 between adjacent sub-openings 2011a, such that the thickened portion 202 is located above the first opening 2011, thereby allowing the paste to infiltrate through the thickened portion 202 and the first opening 2011, and thus obtaining the first connecting portion 22 having a higher printing height.

It should be noted that, with reference to FIG. 12, the second opening 202a may penetrate through two ends of the thickened portion 202 along the second direction Y (the length extension direction of the second opening 202a). That is, in the second direction Y, the second opening 202a and the first opening 2011 are interconnected. This arrangement prevents the paste from being blocked during printing, which will cause uneven printed fingers, thereby facilitating the formation of flatter printed fingers.

As mentioned above, the strength of a screen printing plate structure with a high opening ratio will be weakened at the corresponding positions of the openings. This issue not only exists at the position where the first opening 2011 for printing the first finger 21 is formed, but also exists at the position where the second opening 202a for printing the first connecting portion 22 is formed.

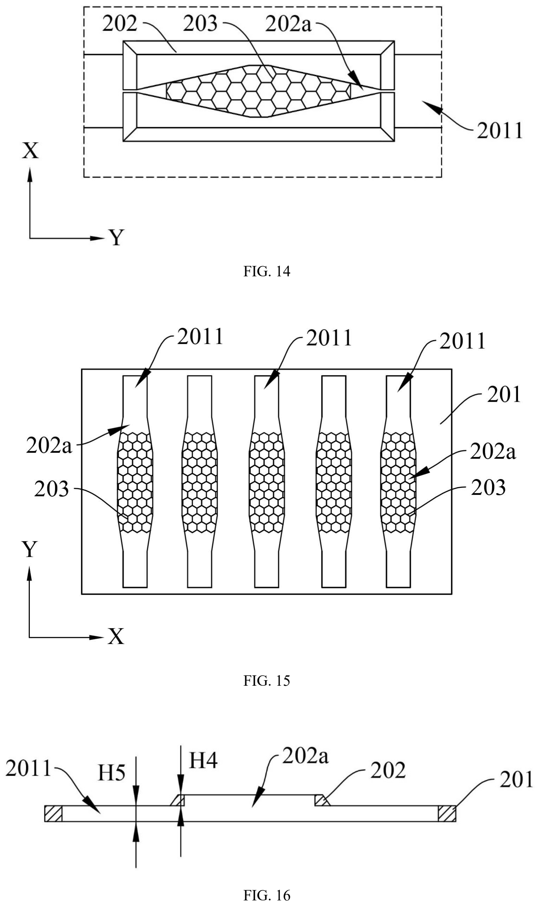

To enhance the structural strength of the substrate 201 at the position corresponding to the second opening 202a, referring to FIG. 13 and FIG. 14, a reinforcement structure 203 is correspondingly disposed on the second opening 202a of the thickened portion 202. The reinforcement structure 203 provides stronger mechanical support for the substrate 201. Moreover, the reinforcement structure 203 may include hollow areas which may connect the second opening 202a, thereby making the second opening 202a and the hollow areas directly below and corresponding to a projection of the hollow areas form a paste infiltration area with a deeper depth, and thus forming the first connecting portion 22 with a higher printing height.

Optionally, the reinforcement structure 203 may adopt, for example, an interwoven steel-wire structure, and a cross-sectional shape of the reinforcement structure 203 may be, for example, a grid, a honeycomb, or a comb-like structure. For example, as shown in FIG. 13 and FIG. 14, FIG. 13 and FIG. 14, the reinforcement structure 203 is in a honeycomb shape.

In some embodiments, the reinforcement structure 203 is located on an upper layer of the thickened portion 202. Specifically, the thickened portion 202 may include a skeleton layer (not shown) and a printing shaping layer (not shown). In a paste flow direction (that is, the direction in which the paste enters the screen printing plate during printing), the skeleton layer is located in front of the printed shaping layer. The skeleton layer is provided with the reinforcement structure 203 exhibiting the honeycomb shape, while the printing shaping layer forms the second opening 202a.

Since the skeleton layer is located above the printing shaping layer, after the paste enters the screen printing plate, the paste first passes through the skeleton layer and then enters the printing shaping layer. That is, the paste ultimately passes through the opening in the printing shaping layer, and permeates down to the half-finished solar cell. By setting the reinforcement structure 203 on the skeleton layer, the affect of the reinforcement structure 203 on the shaping of the paste may be reduced, thereby improving printing quality. Moreover, the reinforcement structure 203 on the skeleton layer may block the paste in the skeleton layer from being scraped away when the scraper scrapes the paste, thereby allowing the paste to be retained in the skeleton layer as much as possible, and thus enabling the paste in the skeleton layer and the printing shaping layer to be cumulatively printed on the surface of the half-finished solar cell. In summary, a height of the paste printed by the reinforcement structure is approximately equal to a sum of the thicknesses of the skeleton layer and the printing shaping layer. It should be noted that, the height of the paste printed by the reinforcement structure is approximately equal to the sum of the thicknesses of the skeleton layer and the printed shaping layer may be interpreted as: the height of the paste printed by the reinforcement structure is equal to the sum of the thicknesses of the skeleton layer and the printed shaping layer; or, the height of the paste printed by the reinforcement structure slightly deviates from the sum of the thicknesses of the skeleton layer and the printed shaping layer.

It should be noted that, as another embodiment, referring to FIG. 15, when a thickened portion 202 is not disposed on the substrate 201 for forming a higher first connecting portion 22, a reinforcement structure 203 may also be provided at the printing openings for forming the first connecting portion 22 to enhance the structural strength of the substrate 201.

In some implementations, with reference to FIG. 16, the height H4 of the thickened portion 202 ranges from 1 µm to 3 µm. Optionally, the height H4 of the thickened portion 202 may range from 1 µm to 2 µm, 1µm to 1.5 µm, or 1.5 µm to 2 µm, and so on. For example, H4 may be 1 µm, 2 µm, or 3 µm, and so on. By setting the height of the thickened portion 202 within the range of 1 µm to 3 µm, the first connecting portion 22 is effectively thickened by 1 µm to 3 µm relative to the base height achievable for the first finger 21, thereby obtaining a height of the first connecting portion 22 that meets the soldering requirements.

In some implementations, the opening depth H5 of the first opening 2011 ranges from 4 µm to 10 µm. Optionally, the opening depth H5 of the first opening 2011 may be range from 4 µm to 6 µm, 4 µm to 8 µm, 6 µm to 8 µm, 6 µm to 10 µm, or 8 µm to 10 µm, and so on. For example, the opening depth H5 of the first opening 2011 may be 5 µm, 6 µm, 7 µm, 8 µm, 9 µm, or 10 µm, and so on.

By limiting the depth of the first opening 2011 within a reasonable range, the height of the formed first finger 21 is lower, thereby reducing the paste consumption and lowering the printing difficulty caused by an excessive height of the printed fingers. Additionally, by controlling the height of the first finger 21 within a reasonable range, an optimal balance between current transportation capability and reduced paste consumption is achieved. If the height of the first finger 21 is too low, it will increase the contact resistance and line resistance of the first finger 21, thereby reducing the current transportation capability of the solar cell 100, If the height of the first finger 21 is too high, it will increase the paste consumption of the first finger 21, which is not benefit to reducing the production cost of the solar cell 100. Therefore, by setting the opening depth H5 of the first opening 2011 within 4 µm to 10 µm, an optimal balance between the current transportation capability and manufacturing cost of the solar cell 100 is achieved.

In a third aspect, the present application also discloses a photovoltaic module (not shown), the photovoltaic module includes the solar cell 100 as described in the above first aspect, or the photovoltaic module includes the solar cell manufactured by the screen printing plate structure as described in the above second aspect. It may be understood that the photovoltaic module, which has the aforementioned solar cell 100, also possesses all the technical effects of the aforementioned solar cell 100. Since the aforementioned technical effects have been detailed in the embodiment of the solar cell 100, they will not be repeated herein.

Certainly, the photovoltaic cell may also include a frame, a photovoltaic glass, an encapsulation material, and so on, which collectively forming a photovoltaic module suitable for various outdoor environments, such as rooftops, building surfaces, or the like, and is widely used in solar photovoltaic systems.

The above provides a detailed introduction to A solar cell, screen a plate structure, and a photovoltaic module disclosed in the embodiments of the present application are described in detail. Specific examples are used in this article to explain the principles and implementation methods of the present application. The description of the above embodiments is only intended to help understanding the solar cell, the screen printing plate structure, and the photovoltaic module of the present application and their core ideas. At the same time, for those skilled in the art, based on the ideas of the present application, there will be changes in specific implementation methods and application scopes. In summary, the content of this specification should not be construed as a limitation to the present application.

## Claims

1. A solar cell (100), comprising:
a half-finished solar cell (10);
a first electrode (20), the first electrode (20) being disposed on the half-finished solar cell (10), the first electrode (20) comprising a plurality of first fingers (21) and a plurality of first connecting portions (22), wherein the plurality of first fingers (21) are arranged at intervals along a first direction (X), each of the first fingers (21) extends along a second direction (Y), the plurality of first connecting portions (22) are arranged at intervals along the first direction (X), the first connecting portion (22) is connected to the first finger (21), and a portion of the first connecting portions (22) are configured to be soldered to solder ribbons; and
a maximum height H1 of the first connecting portion (22) satisfies: 4 µm ≤ H1 ≤ 10 µm, and the first direction (X) intersects with the second direction (Y).

2. The solar cell (100) according to claim 1, wherein a smoothness factor of the first finger (21) is less than a smoothness factor of the first connecting portion (22).

3. The solar cell (100) according to claim 1 or claim 2, wherein the first electrode (20) further comprises a plurality of first busbars (23), the plurality of first busbars (23) are arranged at intervals along the second direction (Y), each of the first busbars (23) extends along the first direction (X), and the first busbar (23) intersects with the first connecting portion (22); and
the maximum height H1 of the first connecting portion (22) is greater than a maximum height of the first busbar (23) corresponding to the first connecting portion (22).

4. The solar cell (100) according to any one of claims 1 to 3, wherein a maximum height of the first finger (21) connected to the first connecting portion (22) is H2, and H1 ranges from 1.2H2 to 3H2.

5. The solar cell (100) according to any one of claims 1 to 4, wherein a maximum height of the first finger (21) connected to the first connecting portion (22) is H2, and a height difference between H1 and H2 ranges from 1 µm to 4 µm.

6. The solar cell (100) according to any one of claims 1 to 5, wherein a maximum height H2 of the first finger (21) connected to the first connecting portion (22) satisfies: 4 µm ≤ H2 ≤ 6 µm.

7. The solar cell (100) according to any one of claims 1 to 6, further comprising a second electrode (30), the second electrode (30) being disposed on the half- finished solar cell (10), the second electrode (30) comprising a plurality of second fingers (31) and a plurality of second connecting portions (32), wherein the plurality of second fingers (31) are arranged at intervals along the first direction (X), each of the second fingers (31) extends along the second direction (Y), the plurality of second connecting portions (32) are arranged at intervals along the first direction (X), the second connecting portion (32) is connected to the second finger (31), and a portion of the second connecting portions (32) are configured to be soldered to the solder ribbons; and
a maximum height of the second connecting portion (32) is H3, and H1 > H3; preferably
the maximum height H3 of the second connecting portion (32) satisfies: 4 µm ≤ H3 ≤ 8 µm.

8. The solar cell (100) according to claim 7, wherein a polarity of the first electrode (20) and a polarity of the second electrode (30) are opposite;
the first electrode (20) is disposed on a front surface (10a) of the half-finished solar cell (10), and the second electrode (30) is disposed on a rear surface (10b) of the half-finished solar cell (10); or
both the first electrode (20) and the second electrode (30) are disposed on a rear surface (10b) of the half-finished solar cell (10).

9. The solar cell (100) according to any one of claims 1 to 8, wherein the first connecting portion (22) comprises a finger connection line (222) and a busbar connection line (221), and at least a portion of the finger connection line (222) overlaps with the busbar connection line (221); preferably
the busbar connection line (221) is covered on the finger connection line (222).

10. The solar cell (100) according to claim 9, wherein a corresponding region between the busbar connection line (221) and the half-finished solar cell (10) has a silicon-containing dielectric layer.

11. The solar cell (100) according to claim 10 or claim 10, wherein a total length L1 of the busbar connection line (221) and the finger connection line (222) in the second direction (Y) ranges from 1 mm to 1.5 mm; and/or,
a minimum width W1 of the busbar connection line (221) and/or the finger connection line (222) in the first direction (X) ranges from 10 µm to 20 µm; and/or,
a maximum width W2 of the busbar connection line (221) in the first direction (X) ranges from 50 µm to 80 µm; and/or,
a maximum width W3 of the finger connection line (222) in the first direction (X) ranges from 25 µm to 40 µm.

12. A screen plate structure (200) applied to a solar cell (100), the solar cell (100) comprising a half-finished solar cell (10), the screen plate structure (200) comprising a substrate (210), the substrate (210) comprising a main body portion (201) and a thickened portion (202), wherein the thickened portion (202) is disposed on the main body portion (201) along a thickness direction of the main body portion (201), the main body portion (201) is provided with a plurality of first openings (2011), the plurality of first openings (2011) penetrate through the main body portion (201) along the thickness direction of the main body portion (201), the plurality of first openings (2011) are arranged at intervals along a first direction (X), and each of the first openings (2011) extends along a second direction (Y);
the thickened portion (202) is provided with a second opening (202a) extending along the second direction (Y), and the second opening (202a) corresponds to at least one of the first openings (2011) and penetrates through the main body portion (201) along the thickness direction of the main body portion (201) to communicate with the first opening (2011); and
the first direction (X) intersects with the second direction (Y).

13. The screen plate structure according to claim 12, wherein each of the first openings (2011) comprises a plurality of sub-openings (2011a), the plurality of sub-openings (2011a) are arranged at intervals along the second direction (Y), the thickened portion (202) is located between at least two adjacent sub-openings (2011a), and the second opening (202a) communicates with the two adjacent sub-openings (2011a).

14. The screen plate structure according to claim 12 or claim 13, wherein a thickness H4 of the thickened portion (202) ranges from 1 µm to 3 µm; and/or
an opening depth H5 of the first opening (2011) ranges from 4 µm to 10 µm.

15. A photovoltaic module, comprising the solar cell according to any one of claims 1 to 11, or comprising the solar cell (100) manufactured by the screen plate structure (200) according to any one of claims 12 to 14.
